# EUROPEAN PATENT SPECIFICATION

(11) **EP 2 192 286 B1**
(45) Date of publication and mention of the grant of the patent: **09.01.2019**
(21) Application number: 09176478.7
(22) Date of filing: 19.11.2009
(51) Int. Cl.: F01P 9/06, F01P 7/14

(54) **Method and system for extra cooling of the coolant in a vehicle´s cooling system**
Verfahren und System für die zusätzliche Kühlung des Kühlmittels im Kühlsystem eines Fahrzeuges
Procédé et système pour le refroidissement supplémentaire du produit de refroidissement dans un système de refroidissement de véhicule

(30) Priority: 26.11.2008 SE 0850102
(43) Date of publication of application: 02.06.2010
(73) Proprietor: Scania CV AB (publ), 151 87 Södertälje (SE)
(72) Inventor: Hall, Ola, 117 67 Stockholm (SE)
(74) Representative: Scania CV AB

(56) References cited:
- EP-A1- 1 291 206
- DE-U1- 8 713 443
- US-A1- 2004 194 949

## Description

### TECHNICAL FIELD

The present invention relates generally to cooling systems in vehicles and particularly to cooling systems which comprise at least a compressor-driven closed refrigerant circuit with a condenser and an evaporator. The invention relates more specifically to a method and a system for extra cooling of the coolant in a vehicle's cooling circuit to make possible more effective cooling of units in the vehicle which are usually cooled by an air-cooled low-temperature radiator.

### TECHNICAL BACKGROUND

The development of vehicles is proceeding towards increasingly advanced and complex systems intended to achieve better functionality, higher efficiency etc. This applies not least to large, heavy and commercial vehicles and may involve control units, charge air coolers, EGR coolers etc. Many of these units generate heat which has to be cooled away in a suitable manner.

The units are usually connected to a so-called passive cooling system in the vehicle which cools away part of the surplus heat via an air-cooled radiator. Particularly when the vehicle is travelling in areas with warm climates, it is becoming increasingly difficult to achieve sufficiently effective cooling, and various units have to operate in unfavourable temperature conditions. The difference between the temperature of the coolant and the temperature of surrounding air decreases and the radiator's ability to cool heat away is greatly reduced. This means, inter alia, that more advanced and tolerant, and hence more expensive, components capable of operating at higher temperatures have to be used in the vehicle. However, higher charge air and EGR temperatures result in poorer engine efficiency, leading to higher fuel consumption, and control units, e.g. for engine control, which are exposed to too much heat have a generally shorter service life or are more expensive to manufacture. A known way of cooling control units is to carry the heat away via the diesel fuel EP1291206 shows a known cooling system.

The state of the art does not indicate, however, a simple and effective way of lowering the temperature of a vehicle's coolant by means of a compressor-driven refrigerant circuit.

### OBJECTS AND MOST IMPORTANT CHARACTERISTICS OF THE INVENTION

The object of the invention is to solve said problems and propose a method and a system which result in better and more effective cooling of the units and components in the vehicle which need better cooling in order to operate effectively.

A further object of the invention is to replace the normal passive cooling, via the vehicle's air-cooled radiator, by active cooling which results in more effective cooling of the coolant than can be effected by passive cooling, and is for example particularly advantageous when the vehicle is travelling in warm surroundings.

A further object of the invention is to improve the efficiency of the cooled units and components in the vehicle and thereby achieve lower fuel consumption, less environmental impact and lower operating costs.

A further object of the invention is to make it possible for the cooled units in the vehicle to be manufactured on the basis of less expensive components and/or for their service life to be lengthened.

A further object of the invention is to propose a solution which uses the vehicle's normal cooling circuit and existing air-cooled radiator.

A further object of the invention is to propose a simple compact solution for which it is easy to find space in a vehicle.

These said and further objects are achieved according to the invention by a method and a system according to the features indicated in claims 1 and 3.

The invention is effected substantially by a compressor-driven refrigerant circuit being provided in the vehicle and its secondary side being connected to the vehicle's existing low-temperature cooling circuit which is for example used for cooling the charge air, the EGR gases, various control units etc. More specifically, the condenser of the refrigerant circuit is connected to the vehicle's cooling circuit upstream of the radiator so that at least part of the warmed coolant in the cooling circuit passes the condenser's heat exchanger, whereby the coolant is further warmed before being returned to the vehicle's cooling circuit immediately before the radiator. The thus extra-warmed coolant flows in through the radiator, which consequently becomes warmer than would otherwise normally be the case. As the difference in temperature between the coolant in the radiator and the surrounding air which cools the radiator, e.g. by means of a fan, increases, so too does the radiator's cooling effect, i.e. more heat can be given off from the radiator to the surrounding air.

After the coolant has passed and been cooled in the radiator, i.e. just downstream of the radiator, at least part of the coolant is led into and through the heat exchanger of the compressor-driven refrigerant circuit, which heat exchanger is co-assembled with the evaporator, in which heat exchanger it is further cooled. The coolant is thereafter pumped back into the vehicle's cooling circuit downstream of the radiator and proceeds to the units which are to be cooled in the vehicle. The result is extra cooling of the cooling circuit's coolant, thereby ensuring sufficient cooling of vital units in the vehicle.

The invention does in principle make it possible to achieve a coolant temperature in the vehicle's cooling circuit, after the radiator, which is actually cooler than the surrounding air used for cooling the radiator.

There is of course an energy and hence a fuel cost in running a compressor system according to the invention, but more energy and fuel are saved in that, for example, the vehicle's engine can operate in optimum conditions, resulting in better efficiency and lower fuel consumption.

By increasing the temperature of the coolant before it passes through the low-temperature radiator it is therefore possible to cool away more heat from the vehicle's coolant system. This is because the greater the difference between the temperature of the surrounding air, i.e. the cooling air which passes transversely through the radiator, and the temperature of the coolant which is pumped through the radiator, the greater the effect generally exerted by the radiator.

Further features and advantages of the invention are indicated by the more detailed description of the invention set out below and the attached drawings and other claims.

### BRIEF LIST OF THE DRAWINGS

The invention is described below in more detail in the form of preferred embodiment examples with reference to the attached drawings.

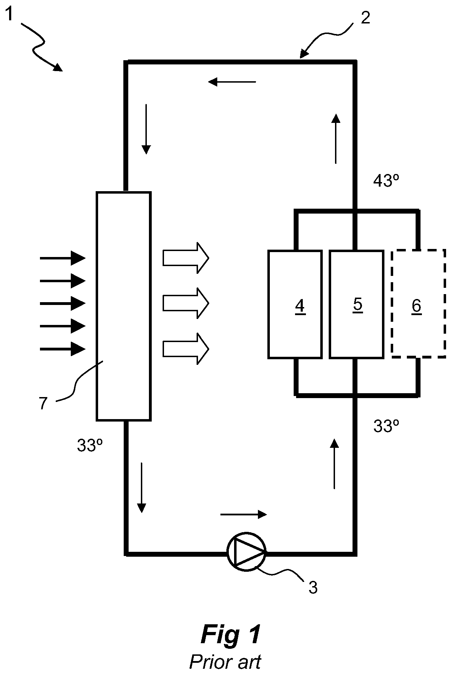

**Figure 1** represents the state of the art within the field and depicts schematically a simple cooling system based on so-called passive cooling in a vehicle.

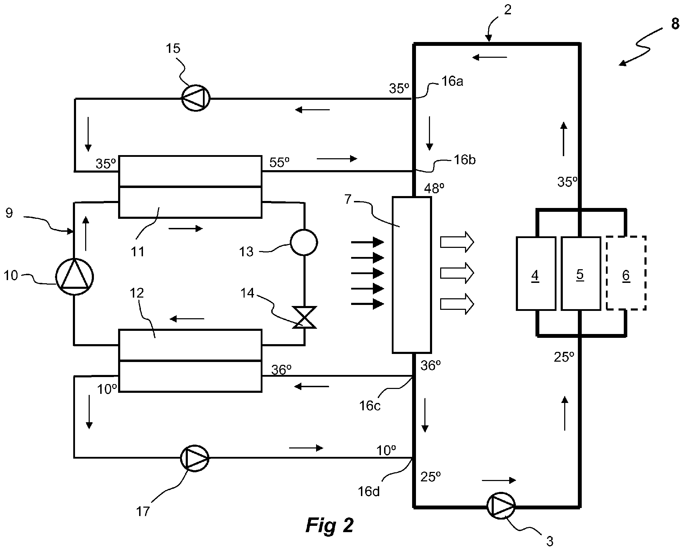

**Figure 2** depicts schematically a so-called active cooling system according to the invention in which a compressor-driven refrigerant circuit is connected by lines to the vehicle's existing cooling circuit and at least part of the coolant passes at least one of the heat exchangers for the evaporator and/or condenser in the compressor-driven refrigerant circuit.

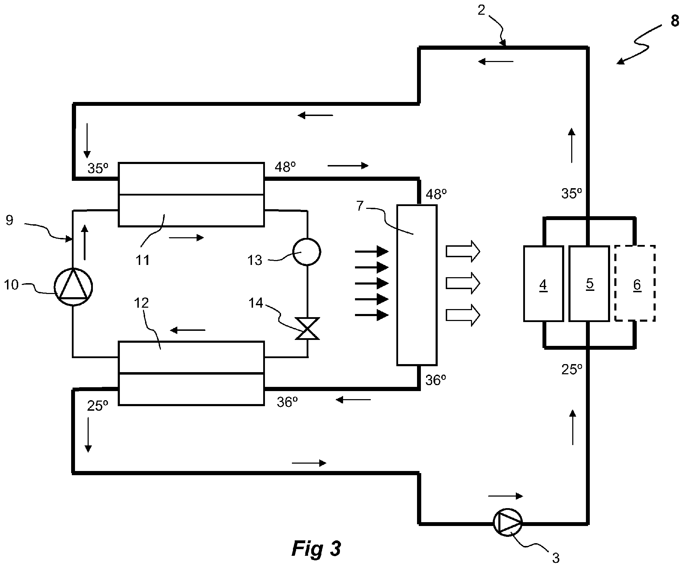

**Figure 3** depicts schematically an alternative embodiment example of the invention according to Figure 2, but in which the whole coolant flow in the vehicle's cooling circuit is led through the condenser and evaporator of the compressor-driven refrigerant circuit.

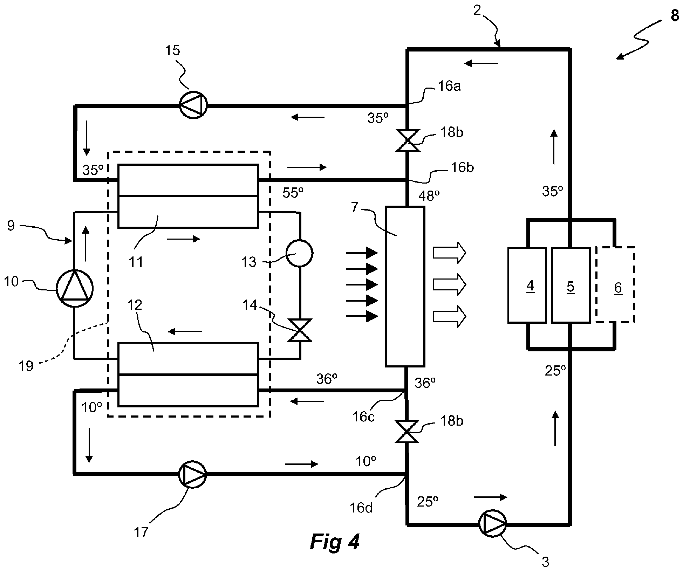

**Figure 4** depicts schematically a further alternative embodiment example of the invention according to Figure 2, but in which it is possible for the amount of coolant from the vehicle's cooling circuit to be regulated so that a larger or smaller amount can be led via the condenser and/or evaporator of the compressor-driven refrigerant circuit.

### DESCRIPTION OF PREFERRED EMBODIMENTS

**Figure 1** depicts the state of the art within the field and illustrates a simple example of a vehicle-based cooling system **1** with ordinary "passive" cooling whereby the coolant, usually in the form of a water and glycol mixture, is pumped round in a substantially closed cooling circuit **2** by a, for example, mechanically driven pump **3.** The coolant passes through one or more units **4-6** in the vehicle which need cooling. These may be the vehicle's engine, an engine control unit, an EGR cooler, a charge air cooler etc. The coolant flows on through an air-cooled low-temperature radiator **7** before being led back to the pump **3.** The cooling effect of the radiator **7** is limited inter alia by the temperature of the surrounding air and the velocity of the air through the radiator **7,** and decreases considerably when, for example, the vehicle is travelling in areas of high air temperature. This means that sufficient cooling cannot always be achieved, resulting in poorer efficiency of vital units and functions in the vehicle, and higher fuel costs.

**Figure 2** depicts schematically an "active" cooling system **8** according to the invention. A compressor-driven refrigerant circuit **9** is connected by a system of lines to the vehicle's existing low-temperature cooling circuit **2** upstream and downstream respectively of the air-cooled radiator **7.**

The compressor-driven refrigerant circuit **9** comprises in a known manner a hermetically sealed flow circuit which operates by means of a refrigerant medium, usually a gas under pressure. The refrigerant circuit **9** comprises in a known manner a mechanically driven compressor **10**, a condenser **11**, an evaporator **12**, a dry filter **13** and an expansion means **14**, and these components are connected to one another by a system of hoses and/or pipelines. The refrigerant circuit **9** gives off heat via the condenser **11** and absorbs heat via the evaporator **12.** Both the condenser **11** and the evaporator **12** are each here co-assembled with their respective liquid-based heat exchanger. The flow of the refrigerant circuit **9** is effected by the compressor **10** and runs from the compressor **10** through the condenser **11**, in which heat is given off, via the dry filter **13** and the expansion means **14** to the evaporator **12**, in which heat is absorbed, and returns thereafter to the compressor **10**.

At least part of the coolant in the vehicle's cooling circuit **2,** after it has passed units **4-6** and been warmed, is led by a first coolant pump **15** from a first junction **16a** upstream of the radiator **7** through the condenser **11** and its heat exchanger, in which it is further warmed. The thus extra-warmed coolant is thereafter led back to the cooling circuit **2** at a second junction **16b**, likewise situated upstream of the radiator **7** but downstream of the first junction **16a**, and is thereafter led through the radiator **7**, in which the coolant is cooled by surrounding air.

Figures 1 and 2 indicate at various points examples of typical temperature levels which may occur in a normal operating situation. These temperatures are representative of an ambient temperature of about 30 degrees and are merely examples and may of course vary greatly between different operating situations with different load conditions etc.

Downstream of the radiator **7**, at least part of the thus air-cooled coolant is pumped, via a third junction **16c**, through the heat exchanger of the evaporator **12** by a second coolant pump **17** and is there further cooled before the coolant is led back to the cooling circuit **2** via a fourth junction **16d** situated downstream of the radiator **7** and also downstream of the third junction **16c.**

The result is an extra-cold coolant which can more effectively cool the units/components in the vehicle which need better cooling. The invention makes it possible for the coolant's temperature after the radiator **7** to be lowered so that it is actually below the temperature of the surrounding air.

**Figure 3** depicts schematically an alternative embodiment example of the invention in which all of the coolant passes the condenser and evaporator of the refrigerant circuit. The result is a single common flow in the cooling circuit **2,** and the size of the heat exchanger of the condenser **11** and the heat exchanger of the evaporator **12** and the size of the pipelines of the refrigerant circuit have to be increased. Having the whole coolant flow passing the condenser **11** and the evaporator **12** makes it possible to achieve a more effective heat exchange in these components, improving the efficiency of the cooling system. The only further item needed in this system is a single common coolant pump **3**, since there are no junction points or partial flows other than at the units **4-6** which are to be cooled.

**Figure 4** depicts schematically a further alternative embodiment example of the invention. Arranging first and second valves **18a,b** in the cooling circuit **2**, upstream and downstream respectively of the radiator **7**, the first valve being between the first and second junctions **16a,b** and the second valve between the third and fourth junctions **16c,d**, makes it possible for the amount of coolant passing through the condenser **11** and evaporator **12** respectively to be regulated as desired. The valves **18a,b** may either be controlled so that they are fully open or fully closed or they may be regulated so that they gradually open or close the flow so that a greater or smaller amount of coolant can be led through the condenser **11** and the evaporator **12** of the compressor-driven refrigerant circuit **9**, depending on the cooling requirement on each individual occasion.
The invention also makes it possible for the evaporator **12** and condenser **11**, with their respective heat exchangers, to be co-assembled or integrated in a single common unit **19**, as indicated by a broken-line box in Figure 4, with the object of creating a compact unit for which it is easy to find space in the vehicle and which can deliver both warm and cold liquid. The temperature values indicated in Figure 4 refer to an operating situation in which the valves **18a,b** are at least partly open.
The invention is described above with reference to various preferred embodiments. The invention is of course not limited to the embodiments described, which are only to be regarded as examples. Other variants of the invention are therefore also perfectly possible within the scope of protection of the attached claims.

## Claims

1. A method for cooling of coolant in a vehicle's cooling circuit comprising a refrigerant circuit (9) driven by a compressor (10), and with a condenser (11), an evaporator (12) and a radiator (7),
**characterised by**
- connecting the liquid-cooled condenser (11) of the refrigerant circuit to the vehicle's cooling circuit (2) upstream of the radiator (7)such that the coolant leaves the coolant circuit (2) upstream of the radiator (7), goes through the condenser (11) and then returns to coolant circuit (2) upstream of the radiator (7), and connecting the liquid-cooled evaporator to the vehicle's cooling circuit (2) downstream of the radiator (7) such that the coolant leaves the coolant circuit (2) downstream of the radiator (7), goes through the evaporator (12) and then returns to coolant circuit (2) downstream of the radiator (7), and
- using the refrigerant circuit (9) to lower the coolant's temperature in the vehicle's cooling circuit (2) downstream of the radiator (7)
- cooling the coolant in the vehicle's cooling circuit (2) to a temperature which is below the temperature of the surrounding air.

2. A method according to claim 1,
**characterised by**
- controlling the coolant flow from the cooling circuit (2) so that at least part of the coolant passes the condenser (11) and evaporator (12) of the refrigerant circuit (9).

3. A system for cooling of coolant in a vehicle's cooling circuit comprising a refrigerant circuit (9) driven by a compressor (10), and with a condenser (11), an evaporator (12) and a radiator (7),
**characterised**
- **in that** the refrigerant circuit (9) is connected to the vehicle's cooling circuit (2) upstream such that the coolant leaves the coolant circuit (2) upstream of the radiator (7), goes through the condenser (11) and then returns to coolant circuit (2) upstream of the radiator (7), and downstream of the radiator (7) such that the coolant leaves the coolant circuit (2) downstream of the radiator (7), goes through the evaporator (12) and then returns to the coolant circuit (2) downstream of the radiator, and
- that the refrigerant circuit (9) is adapted to lowering coolant's temperature in the vehicle's cooling circuit (2) downstream of the radiator (7)
**in that** the refrigerant circuit (9) is adapted to cooling the coolant in the cooling circuit (2) to a temperature which is below the temperature of the surrounding air.

4. A system according to claim 3, **characterised**
- **in that** at least one valve (18a,b) is provided upstream and/or downstream of the radiator (7) and is adapted to controlling the flow in the vehicle's cooling circuit (2) so that at least part of the coolant passes the condenser (11) and the evaporator (12).

## Patentansprüche

1. Verfahren zum Kühlen von Kühlmittel in einem Kühlkreislauf eines Fahrzeugs, umfassend einen Kältemittelkreislauf (9), der von einem Kompressor (10) angetrieben wird, und mit einem Kondensator (11), einem Verdampfer (12) und einem Kühler (7),
**gekennzeichnet durch**
- Verbinden des flüssigkeitsgekühlten Kondensators (11) des Kältemittelkreislaufs mit dem Kühlkreislauf (2) des Fahrzeugs stromaufwärts des Kühlers (7), sodass das Kühlmittel den Kühlkreislauf stromaufwärts des Kühlers (7) verlässt, **durch** den Kondensator (11) fließt und dann in den Kühlkreislauf (2) stromaufwärts des Kühlers (7) zurückkehrt, und Verbinden des flüssigkeitsgekühlten Verdampfers mit dem Kühlkreislauf (2) des Fahrzeugs stromabwärts des Kühlers (7), sodass das Kühlmittel den Kühlkreislauf (2) stromabwärts des Kühlers (7) verlässt, **durch** den Verdampfer (12) fließt und dann in den Kühlkreislauf (2) stromabwärts des Kühlers (7) zurückkehrt, und
- Nutzen des Kältemittelkreislaufs (9), um die Temperatur des Kühlmittels in dem Kühlkreislauf (2) des Fahrzeugs stromabwärts des Kühlers (7) zu verringern;
- Kühlen des Kühlmittels in dem Kühlkreislauf (2) des Fahrzeugs auf eine Temperatur, die unterhalb der Temperatur der umgebenden Luft ist.

2. Verfahren nach Anspruch 1,
**gekennzeichnet durch**
- Steuern des Kühlmittelflusses des Kühlkreislaufs (2), sodass mindestens ein Teil des Kühlmittels den Kondensator (11) und den Verdampfer (12) des Kältemittelkreislaufs (9) passiert.

3. System zum Kühlen von Kühlmittel in einem Kühlkreislauf eines Fahrzeugs, umfassend einen Kältemittelkreislauf (9), der von einem Kompressor (10) angetrieben wird, und mit einem Kondensator (11), einem Verdampfer (12) und einem Kühler (7),
**dadurch gekennzeichnet, dass**
- der Kältemittelkreislauf (9) mit dem Kühlkreislauf (2) des Fahrzeugs stromaufwärts verbunden ist, sodass das Kühlmittel den Kühlkreislauf (2) stromaufwärts des Kühlers (7) verlässt, durch den Kondensator (11) fließt und dann in den Kühlkreislauf (2) stromaufwärts des Kühlers (7) zurückkehrt, und stromabwärts des Kühlers (7) verbunden ist, sodass das Kühlmittel den Kühlkreislauf (2) stromabwärts des Kühlers (7) verlässt, durch den Verdampfer (12) fließt und dann in den Kühlkreislauf (2) stromabwärts des Kühlers zurückkehrt, und
- der Kältemittelkreislauf (9) dazu eingerichtet ist, die Temperatur des Kühlmittels in dem Kühlkreislauf (2) des Fahrzeugs stromabwärts des Kühlers (7) zu senken,
- der Kältemittelkreislauf (9) dazu eingerichtet ist, das Kühlmittel des Kühlkreislaufs (2) auf eine Temperatur zu kühlen, die unterhalb der Temperatur der umgebenden Luft ist.

4. System nach Anspruch 3,
**dadurch gekennzeichnet, dass**
- mindestens ein Ventil (18a, b) stromaufwärts und/oder stromabwärts des Kühlers (7) angeordnet ist und dazu eingerichtet ist, den Fluss in dem Kühlkreislauf (2) des Fahrzeugs zu steuern, sodass mindestens ein Teil des Kühlmittels den Kondensator (11) und den Verdampfer (12) passiert.

## Revendications

1. Procédé pour le refroidissement d'un produit de refroidissement dans un système de refroidissement de véhicule comprenant un circuit de produit de refroidissement (9) entraîné par un compresseur (10) et avec un condenseur (11), un évaporateur (12) et un radiateur (7), **caractérisé par**
- connecter le condenseur (11) refroidi par liquide du circuit de produit de refroidissement au circuit de refroidissement (2) du véhicule en amont du radiateur (7) de façon que le produit de refroidissement quitte le circuit de refroidissement (2) en amont du radiateur (7), passe par le condenseur (11) et retourne ensuite au circuit de refroidissement (2) en amont du radiateur (7), et connecter l'évaporateur refroidi par liquide au circuit de refroidissement (2) du véhicule en aval du radiateur (7) de façon que le produit de refroidissement quitte le circuit de refroidissement (2) en aval du radiateur (7), passe par l'évaporateur (12) et retourne ensuite au circuit de refroidissement (2) en aval du radiateur (7),
- utiliser le circuit de produit de refroidissement (9) pour baisser la température du produit de refroidissement dans le circuit de refroidissement (2) du véhicule en aval du radiateur (7)
- refroidir de produit de refroidissement dans le circuit de refroidissement (2) à une température qui est inférieure à la température de l'air qui l'entoure.

2. Procédé selon la revendication 1, **caractérisé par**
- contrôler le flux de produit de refroidissement partant du circuit de refroidissement (2) de façon qu'au moins une partie du produit de refroidissement passe par le condenseur (11) et l'évaporateur (12) du circuit de produit de refroidissement (9).

3. Système pour le refroidissement d'un produit de refroidissement dans un système de refroidissement de véhicule comprenant un circuit de produit de refroidissement (9) entraîné par un compresseur (10) et avec un condenseur (11), un évaporateur (12) et un radiateur (7),
**caractérisé**
- **en ce que** circuit de produit de refroidissement (9) est connecté au circuit de refroidissement (2) du véhicule en amont de façon que le produit de refroidissement quitte le circuit de refroidissement (2) en amont du radiateur (7), passe par le condenseur (11) et retourne ensuite au circuit de refroidissement (2) en amont du radiateur (7), et en aval du radiateur (7) de façon que le produit de refroidissement quitte le circuit de refroidissement (2) en aval du radiateur (7), passe par l'évaporateur (12) et retourne ensuite au circuit de refroidissement (2) en aval du radiateur (7), et
- **en ce que** le circuit de produit de refroidissement (9) est adapté pour baisser la température du produit de refroidissement dans le circuit de refroidissement (2) du véhicule en aval du radiateur (7),
- **en ce que** le circuit de produit de refroidissement (9) est adapté pour refroidir de produit de refroidissement dans le circuit de refroidissement (2) à une température qui est inférieure à la température de l'air qui l'entoure.

4. Système selon la revendication 3, **caractérisé**
- **en ce qu'**au moins une valve (18a, 18b) est disposée en amont et/ou en aval du radiateur (7) et est adaptée pour contrôler le flux dans le circuit de refroidissement (2) du véhicule de façon qu'au moins une partie du produit de refroidissement passe par le condenseur (11) et l'évaporateur (12).
